(19) Europäisches Patentamt / European Patent Office / Office européen des brevets

(11) **EP 4 535 378 A1**

(12) **EUROPEAN PATENT APPLICATION**

(43) Date of publication:
**09.04.2025 Bulletin 2025/15**

(21) Application number: **24203505.3**

(22) Date of filing: **30.09.2024**

(51) International Patent Classification (IPC):
*H01F 1/153* (2006.01)  *H05K 9/00* (2006.01)

(52) Cooperative Patent Classification (CPC):
**H01F 1/15333; H01F 1/15308; H01F 1/15383; H05K 9/0075**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **03.10.2023 JP 2023172367**

(71) Applicant: **Proterial, Ltd.**
**Tokyo 135-0061 (JP)**

(72) Inventors:
• **MIURA, Hisayuki**
**Tokyo, 135-0061 (JP)**
• **SATAKE, Hirotaka**
**Tokyo, 135-0061 (JP)**

(74) Representative: **Berggren Oy**
**P.O. Box 16**
**Eteläinen Rautatiekatu 10A**
**00101 Helsinki (FI)**

(54) **MAGNETIC SHIELD SHEET**

(57)  Provided is a magnetic shield sheet (40) in which deterioration in appearance and degradation in magnetic properties are suppressed even when used in a high-temperature environment. A magnetic shield sheet (40) is a laminated body including a first resin layer (12), a first adhesive layer (14), a magnetic layer (16), a second adhesive layer (18), and a second resin layer (20) in this order, in which the magnetic layer 816) is a magnetic layer containing a magnetic material having a magnetos- triction constant $\lambda$ of 30 or less and having a thickness of from 8 $\mu$m to 25 $\mu$m, each of the first resin layer (12) and the second resin layer (20) is a resin layer containing a resin having a melting point or a sublimation point of 250°C or higher and having a thickness of from 1 $\mu$m to 24 $\mu$m, and each of the first adhesive layer (14) and the second adhesive layer (18) is an adhesive layer containing an adhesive having a melting point of 150°C or higher and having a thickness of from 1 $\mu$m to 10 $\mu$m.

FIG.3A

EP 4 535 378 A1

**Description**

BACKGROUND OF THE INVENTION

Field of the Invention

The present disclosure relates to a magnetic shield sheet.

Description of the Related Art

In a magnetic shield sheet that can be used as a magnetic shield or an electromagnetic wave shield used for an electronic device or the like, an amorphous material or a nanocrystalline material is used as a magnetic ribbon having excellent magnetic properties, that is, a magnetic layer. The nanocrystalline material suitable for the magnetic layer can be obtained by quenching a molten metal having an alloy composition that can be adjusted to a nanocrystalline structure such as a Fe-Cu-Nb-(Si,B)-based nanocrystalline structure, molding the molten metal into an elongated body called an amorphous ribbon, and then adjusting the molded molten metal to a nanocrystalline structure by heat treatment. As an example, the nanocrystalline material may be a material in which at least 50% or more of the structure is composed of fine crystal grains having an average crystal grain size of 100 nm or less.

The soft magnetic quenched alloy ribbon of the nanocrystalline material subjected to the heat treatment has lower toughness than that before the heat treatment, and tends to be embrittled. In particular, when the ribbon is crystallized by heat treatment and adjusted to a nanocrystalline structure, the tendency toward embrittlement is significant, resulting in a problem that the ribbon is easily broken during handling.

In a case in which the nanocrystalline material is used for a magnetic shield sheet, if an alloy ribbon in an embrittled state is used, cracks, chips, and the like occur when stress is applied during processing and usage, impairing the performance as a magnetic layer. Therefore, a resin is usually stuck to both surfaces of the soft magnetic alloy ribbon for use as a laminated body.

For this reason, a method has been proposed in which a thermoplastic resin layer is bonded to at least one surface of a magnetic layer to obtain a laminated body (see Japanese Patent Application Laid-Open (JP-A) No. 2007-317769).

The thermoplastic resin has favorable processability, and for example, there is an advantage that a layer that protects the magnetic layer can be easily formed by stacking the thermoplastic resin layer on the magnetic layer and heating them. In addition to the thermoplastic resin, a heat-weldable adhesive, a so-called hot melt adhesive, a double-sided tape, a thermoplastic resin film with a single-sided adhesive layer, or the like is used to protect the magnetic layer.

SUMMARY OF THE INVENTION

However, in recent years, the applications of magnetic shield sheets have bee expanded. For example, the magnetic shield sheets are being used in electronic circuits o automobiles and the like, in addition to suppression of magnetic field noise in electronic device such as smartphones, tablet type information terminals, and mobile phones. In a case in whic a magnetic shield sheet is used in an automobile or the like, it is desirable to use the magneti shield sheet in an environment having a temperature that is higher than the conventional operating temperature range of from -10°C to +80°C, for example, in an environment of 100°C or higher.

Thermoplastic resins, thermoplastic adhesives, and the like that have conventionally been generally used from the viewpoint of processability and the like have low heat resistance. For example, when a thermoplastic resin is used at a high temperature of 100°C or higher, the thermoplastic resin may be re-melted. If the resin is re-melted, problems occur in that the resin layer may be deformed and delaminated from a nanocrystalline material, which forms a magnetic layer, and the resin layer itself may undergo thermal deformation, thermal discoloration, or the like, which may reduce the performance of the resin layer for protecting the magnetic layer made of the nanocrystalline material, resulting in cracks in the magnetic layer, whereby defects such as the nanocrystalline material falling off may occur, reducing its function as a magnetic shield.

An object of an embodiment of the disclosure is to provide a magnetic shield sheet in which deterioration in appearance and degradation in magnetic properties are suppressed even when used in a high-temperature environment.

Specific means for solving the problems include the following aspects.

<1> A magnetic shield sheet comprising a laminated body having a first resin layer, a first adhesive layer, a magnetic layer, a second adhesive layer, and a second resin layer in this order, in which the magnetic layer contains a magnetic material having a magnetostriction constant $\lambda$ of $30 \times 10^{-6}$ or less, the magnetic layer having a thickness of from 8 $\mu$m to 25 $\mu$m, each of the first resin layer and the second resin layer contains a resin having a melting point or a sublimation point of 250°C or higher, and has a thickness of from 1 μm to 24 μm, and each of the first adhesive layer and the second adhesive layer contains an adhesive having a melting point of 150°C or higher, and has a thickness of from 1 μm to 10 μm.

<2> The magnetic shield sheet according to <1>, in which the magnetic layer is an elongated body having a width of from 30 mm to 500 mm, each of the first resin layer, the first adhesive layer, the second adhesive layer, and the second resin layer has a width of 300 mm or more, and a plurality of magnetic layers are arranged in parallel in a longitudinal direction of the elongated body on a surface of the first adhesive layer at an opposite side from a side having the first resin layer.

<3> The magnetic shield sheet according to <1> or <2>, in which a total thickness of the laminated body is from 33 μm to 65 μm.

<4> The magnetic shield sheet according to any one of <1> to <3>, configured in a wound roll shape.

<5> The magnetic shield sheet according to any one of <1> to <4>, in which the magnetic shield sheet is a magnetic shield member obtained by punching the laminated body into any given shape.

<6> The magnetic shield sheet according to any one of <1> to <5>, in which the first adhesive layer and the second adhesive layer contain a thermosetting adhesive, when an area change rate of at least one of the first resin layer or the second resin layer between before and after heating at a temperature for curing the thermosetting adhesive is A%, and a thickness of each of the first resin layer and the second resin layer is B μm, a product of A and B is 30%•μm or less.

(Method of Measuring Area Change Rate)

In accordance with JIS C 2151:2019, ASTM DD1204, a sample is prepared by cutting out a resin film configuring the first resin layer and the second resin layer to a size of 100 mm × 100 mm, the obtained sample of the resin film is heated in a heat treatment furnace under a condition of 200°C × 10 min or 150°C × 30 min according to the temperature for curing the thermosetting adhesive, thermal shrinkage rates in a width direction and a length direction of the resin film before and after the heating are measured by the following method, an area is calculated from the product of the obtained width and length, and an area change rate is measured by the following Formula (a).

area change rate (%) = absolute value of [area of resin film before heating - area of resin film after heating]/area of resin film before heating.

- Method of Measuring Thermal Shrinkage Rate -

(1) A size in the width direction and a size in the length direction of a test piece before heating are measured.
(2) The test piece is placed in a hot air circulating thermostatic chamber, and suspended in a state with a load under time and temperature conditions corresponding to the material of the resin film.
(3) After heating, the test piece is cooled to room temperature, and then a length of the test piece after the heat treatment is measured for the same portion as the test piece measured previously before heating.
(4) Using the obtained value, a thermal shrinkage rate is obtained according to the following Formula (b).

$$\text{Formula (b): thermal shrinkage rate (dimensional change rate) (\%)} = 100 \times (Lo\text{-}L)/Lo$$

In Formula (b), Lo denotes a size of the test piece before the heating test, and L denotes a size of the test piece after the heating treatment.

In the measurement method, the expression "suspended in a state with a load" refers to a state in which "the resin film is suspended without being deformed" by applying a load to such an extent that the resin film is suspended without being deformed such as being wound up, and the load may be appropriately adjusted depending on the material of the resin film.

According to an embodiment of the disclosure, there is provided a magnetic shield sheet in which deterioration in appearance and degradation in magnetic properties are suppressed even when used in a high-temperature environment.

BRIEF DESCRIPTION OF THE DRAWINGS

Fig. 1 is a cross-sectional view schematically illustrating an example of a magnetic shield sheet of the disclosure;

Fig. 2 is a cross-sectional view schematically illustrating an example of a conventional magnetic shield sheet;

Fig. 3A is a schematic configuration diagram illustrating an example of a magnetic shield sheet the disclosure;

Fig. 3B is a schematic cross-sectional view schematically illustrating an example of an overlapping portion in a magnetic layer along line A-A of the magnetic shield sheet illustrated in Fig. 3A of the disclosure;

Fig. 3C is a schematic cross-sectional view schematically illustrating another example of an overlapping portion in a magnetic layer along line A-A of the magnetic shield sheet illustrated in Fig. 3A of the disclosure;

Fig. 4 is a schematic view illustrating an example of a manufacturing apparatus suitable for manufacturing a magnetic shield sheet of the disclosure;

Fig. 5A is a partially enlarged photograph showing an appearance of a magnetic shield sheet of Example 1 after heat treatment;

Fig. 5B is a partially enlarged photograph showing an appearance of a magnetic shield sheet of Comparative Example 1 after heat treatment;

Fig. 6 is a graph showing a relationship between a heating time and a magnetic permeability in a high-temperature storage test for each of the magnetic shield sheet of Example 1 and the magnetic shield sheet of Comparative Example 1;

Fig. 7 is a graph showing magnetic permeabilities at frequencies of 100 Hz and 10,000 Hz for the magnetic shield sheet of Example 1 and the magnetic shield sheet of Comparative Example 1;

Fig. 8 is a graph showing magnetic permeabilities at frequencies of 100 Hz and 10,000 Hz for a magnetic shield sheet of Example 2 and a magnetic shield sheet of Comparative Example 2; and

Fig. 9 is a graph showing a relationship between a product of a thickness of a first resin layer and an area change rate of the resin layer between before and after heat treatment and a magnetic permeability of a laminated body for a magnetic shield sheet having a layer configuration similar to that in Example 1.

## DETAILED DESCRIPTION OF THE INVENTION

Hereinafter, embodiments of the disclosure will be described in detail. The disclosure is not limited in any way to the following embodiments, and can be implemented with appropriate modifications within the scope of the object of the disclosure.

When the embodiments of the disclosure are described with reference to the drawings, descriptions of components and reference numerals that overlap between the drawings may be omitted. Components denoted by the same reference numerals in the drawings refer to the same components. The dimensional ratios in the drawings do not necessarily represent actual dimensional ratios.

In the disclosure, a numerical range indicated using "to" indicates a range including numerical values described before and after "to" as a lower limit value and an upper limit value, respectively. An upper limit value or a lower limit value described in a certain numerical range among the numerical ranges described in a stepwise manner in the disclosure may be replaced with an upper limit value or a lower limit value of another one of the numerical ranges described in the stepwise manner. In addition, among the numerical ranges described in the disclosure, an upper limit value or a lower limit value described in a certain numerical range may be replaced with a value indicated in an example.

In the disclosure, ordinal numbers (e.g., "first" and "second") are terms used to distinguish components, and does not limit the number of components or the priority between the components.

In the disclosure, the term "process" includes not only an independent process but also a process that cannot be clearly distinguished from the other processes as long as the intended purpose of the process is achieved.

In the disclosure, a combination of two or more preferred aspects is a more preferred aspect.

In the disclosure, a magnetic shield sheet has a sheet-like form. When the surface of the magnetic shield sheet is rectangular, the short side is defined as "width", and the long side is defined as "length".

When the magnetic shield sheet is wound in a roll shape, the winding direction is defined as "length direction", and the direction perpendicular to the length direction is defined as "width direction".

When the magnetic shield sheet, which include a magnetic layer, an adhesive layer, and a resin layer, has a ribbon shape in which the long side is five or more times longer than the short side, the sheet may be referred to as an "elongated body".

A magnetic shield sheet of the disclosure is a laminated body including a first resin layer, a first adhesive layer, a magnetic layer, a second adhesive layer, and a second resin layer in this order, in which the magnetic layer is a magnetic layer containing a magnetic material having a magnetostriction constant $\lambda$ of 30 or less and having a thickness of from 8 $\mu$m to 25 $\mu$m, each of the first resin layer and the second resin layer is a resin layer containing a resin having a melting point or a sublimation point of 250°C or higher and having a thickness of from 1 $\mu$m to 24 $\mu$m, and each of the first adhesive layer and the second adhesive layer is an adhesive layer containing an adhesive having a melting point of 150°C or higher and having a thickness of from 1 $\mu$m to 10 $\mu$m.

The magnetic shield sheet of the disclosure has a laminated body structure in which both surfaces of an alloy ribbon as the magnetic layer are protected by the resin layers via the adhesives.

Here, the adhesive layer contacting one surface of the magnetic layer is referred to as first adhesive layer, and the layer that adheres to the magnetic layer via the first adhesive layer is referred to as first resin layer. In addition, the adhesive layer contacting the surface opposite to the surface having the first adhesive layer of the magnetic layer is referred to as second adhesive layer, and the layer that adheres to the magnetic layer via the second adhesive layer is referred to as second resin layer.

The laminated body constituting the magnetic shield sheet of the disclosure will be described with reference to the drawings.

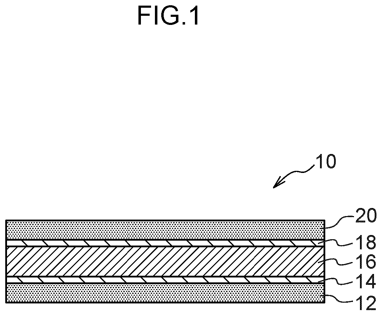

Fig. 1 is a cross-sectional view schematically illustrating an example of a magnetic shield sheet of the disclosure. A magnetic shield sheet 10 illustrated in Fig. 1 includes a first resin layer 12, a first adhesive layer 14, a magnetic layer 16, a second adhesive layer 18, and a second resin layer 20 in this order.

The first resin layer 12, the first adhesive layer 14, the second adhesive layer 18, and the second resin layer 20 protect the magnetic layer 16 containing a magnetic material from both surfaces thereof to suppress damage to the magnetic layer 16 or delamination of the magnetic layer 16 from the first resin layer or the second resin layer even if the magnetic shield sheet 10 is deformed.

In the magnetic shield sheet of the disclosure, the magnetic layer is a magnetic layer containing a magnetic material having a magnetostriction constant $\lambda$ of 30 or less and having a thickness of from 8 $\mu$m to 25 $\mu$m, each of the first resin layer and the second resin layer is a resin layer containing a resin having a melting point or a sublimation point of 250°C or higher and having a thickness of from 1 $\mu$m to 24 $\mu$m, and each of the first adhesive layer and the second adhesive layer is an adhesive layer containing an adhesive having a melting point of 150°C or higher and having a thickness of from 1 $\mu$m to 10 $\mu$m. Therefore, it is considered that, for example, in a case in which the adhesive layer contains a thermosetting resin, even if the adhesive layer is heated and cured, deformation of the adhesive layers and the resin layers is suppressed, and undesired damage to the magnetic layer is suppressed. Specifically, it is considered that the effect of the disclosure is achieved by the superior heat resistance of the resin component itself contained in the resin layers and the adhesive layers in combination with the relatively thin thickness of each layer.

Each layer will be described in detail later.

In a conventionally known magnetic shield sheet, a thermoplastic resin is generally used for a resin layer that is a protective layer of a magnetic layer, and it is often that the resin layer has a thickness of more than 30 $\mu$m and even about 50 $\mu$m.

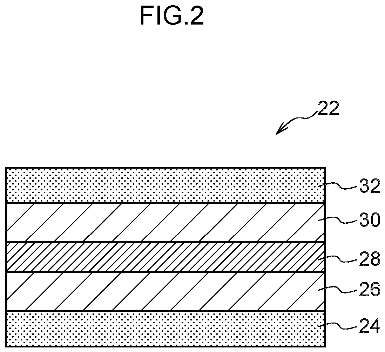

Fig. 2 is a cross-sectional view schematically illustrating an example of a conventionally known magnetic shield sheet. A magnetic shield sheet 22 illustrated in Fig. 2 includes a first resin layer 24, a first adhesive layer 26, a magnetic layer 28, a second adhesive layer 30, and a second resin layer 32 in this order, and the layer configurations are similar. Although the layer structure is similar, each of the first resin layer and the second resin layer is a resin layer containing thermoplastic polyethylene a melting point of from 100°C to 150°C and having a thickness of more than 30 $\mu$m, and the adhesive contained in the adhesive layers also includes a thermoplastic adhesive such as a hot melt adhesive. As a result, for example, in a high-temperature environment exceeding 100°C, the thermoplastic resin may be re-melted, and its performance of protecting the magnetic layer may be deteriorated.

The structure of the magnetic shield sheet of the disclosure is not particularly limited except that the magnetic shield sheet is a laminated body including a first resin layer, a first adhesive layer, a magnetic layer, a second adhesive layer, and a second resin layer in this order. The magnetic layer is not necessarily stacked over the entire surfaces of the first resin layer and the first adhesive layer in the magnetic shield sheet, and may be formed only in a local region.

In a region where the magnetic layer is not disposed, the first adhesive layer and the second adhesive layer may be directly bonded to each other.

The regions where the magnetic layer is formed are preferably arranged regularly from the viewpoint of magnetic shielding properties.

In a preferred aspect of the magnetic shield sheet, the magnetic layer is an elongated body having a width of from 30 mm to 500 mm, each of the first resin layer, the first adhesive layer, the second adhesive layer, and the second resin layer has a width of 300 mm or more, and a plurality of magnetic layers are arranged in parallel in a longitudinal direction of the elongated body on a surface of the first adhesive layer on a side opposite to a side having the first resin layer.

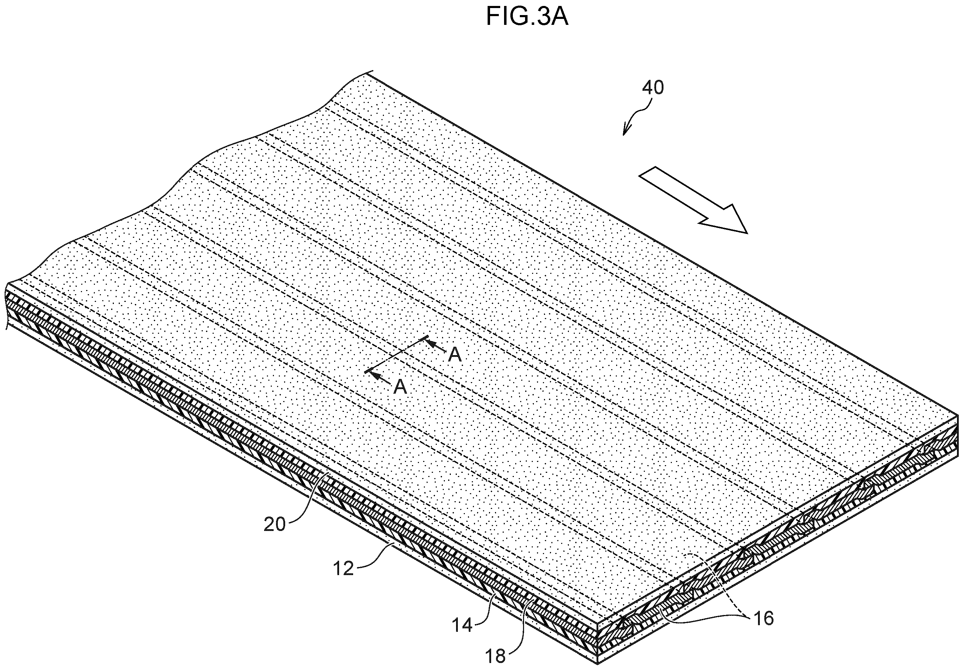

Fig. 3A is a schematic configuration diagram illustrating an example of a magnetic shield sheet in which a plurality of magnetic layers are arranged in parallel on a surface of a first resin layer and a surface of a first adhesive layer adjacent to the first resin layer. In Fig. 3A, in order to clarify the structure, a layer configuration of a magnetic shield sheet 40 is clearly illustrated with a side surface as a cross section.

In the perspective view of the magnetic shield sheet 40 illustrated in Fig. 3A, the second adhesive layer 18 and the second resin layer 20 are stacked on a surface of the magnetic layer 16 on a side opposite to a side contacting the first adhesive layer 14. Although the magnetic layer 16 may not be visible depending on the thickness of the resin layer 20, etc., Fig. 3A is illustrated as a transmission view in order to clarify the shape and arrangement position of the magnetic layer 16.

The plurality of magnetic layers 16 arranged in parallel are arranged to partially overlap one another, because if there is a gap between the adjacent magnetic layers 16, there is a possibility that electromagnetic waves may be transmitted from the gap. In the magnetic layers 16 arranged in parallel, the upper magnetic layer is indicated by a solid line, and an end of the lower magnetic layer arranged with an overlap is indicated by a broken line.

In Fig. 3A, an arrow shown adjacent to the magnetic shield sheet 40 indicates the longitudinal direction of the magnetic shield sheet 40.

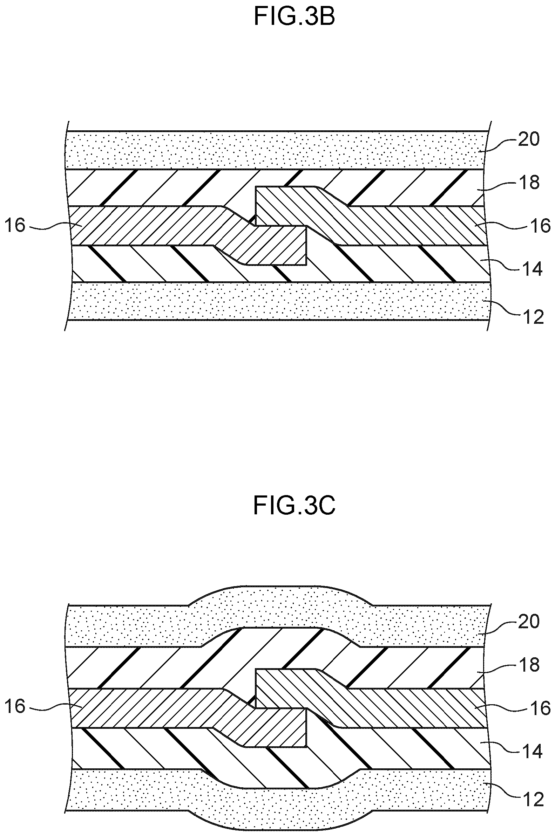

Fig. 3B is a schematic cross-sectional view schematically illustrating an example of a cross section taken along line A-A of the magnetic shield sheet illustrated in Fig. 3A.

In the cross section illustrated in Fig. 3B of the magnetic shield sheet 40 taken along line A-A, that is, in a cross section in a width direction, the magnetic layers 16 are formed to overlap each other in the width direction of the magnetic shield sheet 40 as illustrated in Fig. 3B. In the example illustrated in Fig. 3B, the first adhesive layer 14 and the second adhesive layer 18 are formed to be thinner in a region where the magnetic layers 16 overlap each other than in a region where the magnetic layers 16 do not overlap each other, and the magnetic shield sheet has an almost uniform thickness as a whole.

Fig. 3C is a schematic cross-sectional view schematically illustrating another example of a cross section taken along line A-A of the magnetic shield sheet illustrated in Fig. 3A, which is different from Fig. 3B.

In the cross section taken along line A-A of the magnetic shield sheet 40 as illustrated in Fig. 3C, the magnetic layers 16 are formed to overlap each other in the width direction of the magnetic shield sheet 40 as illustrated in Fig. 3C. Meanwhile, in an aspect illustrated in Fig. 3C, even in a region where the magnetic layers 16 overlap each other, the first adhesive layer 14 and the second adhesive layer 18 are formed to have a thickness that is substantially the same as the thickness in a region where the magnetic layers 16 do not overlap each other. In the above-described aspect, it is described as an example that the adhesiveness in the overlapping portion is similar to that in the other region, but the magnetic shield sheet 40 has a thickness that is slightly larger in the portion where the magnetic layers 16 overlap each other than in the other region as a whole.

The aspect of the overlapping portion between the magnetic layers is not limited to the above-described example, and the overlapping width between the magnetic layers 16 and the thicknesses of the first adhesive layer 14 and the second adhesive layer 18 in the overlapping region between the magnetic layers 16 can be appropriately changed according to the intended use of the magnetic shield sheet.

In a case in which the magnetic layer of the elongated body is stacked on a resin layer having a larger width with the adhesive layer interposed therebetween, the magnetic layer of the elongated body can have a width of from 40 mm to 550 mm, preferably from 35 mm to 520 mm, and more preferably from 30 mm to 500 mm, from the viewpoint of productivity and magnetic blocking properties of the obtained magnetic shield sheet.

In a case in which the magnetic layer of the elongated body is stacked on a resin layer having a larger width, the width of the resin layer is preferably 3 times or more the maximum value for the width of the magnetic layer, more preferably 5 times or more the maximum value for the width of the magnetic layer, and still more preferably 10 times or more the maximum value for the width of the magnetic layer, from the viewpoint of productivity.

<<Layer Configuration of Magnetic Shield Sheet>>

Next, each layer of the magnetic shield sheet of the disclosure will be described. As described above, the magnetic shield sheet of the disclosure includes a first resin layer, a first adhesive layer, a magnetic layer, a second adhesive layer, and a second resin layer in this order.

<First Resin Layer and Second Resin Layer>

The first resin layer and the second resin layer function as layers that protect the magnetic layer.

Each of the first resin layer and the second resin layer is a resin layer containing a resin having a melting point or a sublimation point of 250°C or higher and having a thickness of from 1 $\mu$m to 24 $\mu$m.

Examples of the resin having a melting point or a sublimation point of 250°C or higher include polyimide [melting point: none, heat-resistant temperature: 400°C], polyphenylene sulfide (PPS) [melting point: from 260°C to 270°C, weighted deflection temperature: 1.8 MPa], an aramid resin that is an aromatic polyamide resin [melting point: none (for sublimation), heat-resistant temperature: 400°C], and high heat-resistant polyethylene terephthalate (high heat-resistant PET) [melting point: unknown, heat-resistant temperature: 250°C], and the PPS and the aramid resin are preferable from the viewpoint of heat resistance and dimensional stability.

The melting point or sublimation point of the resin [hereinafter, also referred to as specific resin] contained in the first resin layer and the second resin layer is 250°C or higher, preferably 260°C or higher, and more preferably 270°C or higher, from the viewpoint of the protection of the magnetic layer. The upper limit of the melting point or the sublimation point of the specific resin is not particularly limited, but the melting point can be 300°C or lower and the sublimation point can be 500°C or lower from the viewpoint of processability.

In the disclosure, as the melting point or sublimation point of the resin contained in the resin layer, a value in a general literature is adopted.

The resin contained in the first resin layer and the resin contained in the second resin layer may be identical or different, but they are preferably identical, from the viewpoint of stability when formed into a laminated body, because the first resin layer and the second resin layer coincide with each other in thermal behavior.

The first resin layer and the second resin layer may contain other known components in addition to the specific resin as long as the effect is not impaired.

Examples of other components include an organic solvent, a surfactant, a plasticizer, and a colorant.

The first resin layer and the second resin layer have a thickness in a range of from 1 $\mu$m to 24 $\mu$m. In a case in which the thickness of each resin layer is more than 24 $\mu$m, it is difficult to deform the laminated body, which may hinder the obtained magnetic shield sheet from being placed along a curved surface or a bent surface. In addition, in a case in which the thickness is less than 1 $\mu$m, the handleability at the time of stacking the protective layer is deteriorated, and the function of protecting the magnetic layer may not be sufficiently obtained. When the thickness of each resin layer is in the above-described range, the protection of the magnetic layer and the suppression of deformation of magnetism caused by thermal deformation of the magnetic shield sheet is favorable.

The thickness of each resin layer is preferably 2 $\mu$m or more, more preferably 3 $\mu$m or more, and still more preferably 4 $\mu$m or more, from the viewpoint of the protection of the magnetic layer.

The upper limit of the thickness of the resin layer is preferably 20 $\mu$m or less, more preferably 15 $\mu$m or less, and still more preferably 10 $\mu$m or less, from the viewpoint of the flexibility of the magnetic shield sheet and the dimensional stability during heating.

The thickness of the resin layer can be measured with a contact-type film thickness meter.

In the disclosure, thicknesses are measured at five positions of the magnetic shield sheet, and an arithmetic average of the obtained thicknesses is taken as the thickness of the resin layer.

The thickness of each of the resin layer, the adhesive layer, and the like, which will be described later, of the laminated body constituting the magnetic shield sheet of the disclosure can also be measured in the same manner.

In a case in which a thickness of each layer constituting the magnetic shield sheet that already has a laminated structure is measured, the thickness of each layer can be measured by observing a cut surface obtained by cutting the magnetic shield sheet perpendicularly to its surface.

<First Adhesive Layer and Second Adhesive Layer>

The first adhesive layer and the second adhesive layer are located between the resin layers, which serve as layers that protect the magnetic layer, and the magnetic layer to be described later, and have a function of bringing the first resin layer and the second resin layer to adhere to the magnetic layer.

Each of the first adhesive layer and the second adhesive layer is an adhesive layer containing an adhesive having a melting point of 150°C or higher and having a thickness of from 1 $\mu$m to 10 $\mu$m.

The melting point of the adhesive [hereinafter, also referred to as specific adhesive] contained in the first adhesive layer and the second adhesive layer is 150°C or higher, preferably 160°C or higher, and more preferably 170°C or higher. The specific adhesive is preferably a thermosetting adhesive from the viewpoint of heat resistance and dimensional stability. Examples of the thermosetting adhesive include a thermosetting adhesive containing a thermosetting resin selected from an epoxy resin, an unsaturated polyester resin (sheet molding compound (SMC), bulk molding compound (BMC), or the like), a urea resin, a diallyl phthalate resin, a silicon resin, a polyimide, or a polyurethane. Among them, an epoxy resin-based adhesive is preferable from the viewpoint of the easiness in forming the adhesive layer formability and the heat resistance of the obtained adhesive layer. The adhesive layer can also be formed by transferring a resin molded in a sheet shape. For example, the epoxy resin-based adhesive can be molded into a sheet and then transferred to form an adhesive layer, making it easy to form an adhesive layer having a uniform thickness.

The one-liquid cured type epoxy resin-based adhesive is cured when heated to from 150°C to 200°C, and has more favorable heat resistance after being cured as compared with that of a two-liquid cured epoxy resin-based adhesive.

The resin contained in the first resin layer and the resin contained in the second resin layer may be identical or different. It is preferable that the resin contained in the first resin layer and the resin contained in the second resin layer are identical, from the viewpoint of stability when formed into a laminated body, because the first resin layer and the second resin layer coincide with each other in thermal behavior, and deformation caused by thermal stress can be suppressed.

Each of the first adhesive layer and the second adhesive layer has a thickness of from 1 $\mu$m to 10 $\mu$m.

From the viewpoint of securement of adhesiveness between the resin layer and the magnetic layer, the thickness of the adhesive layer is preferably 1 $\mu$m or more, more preferably 2 $\mu$m or more, and still more preferably 4 $\mu$m or more.

From the viewpoint of suppression of size variation caused by heating, the thickness of the adhesive layer needs to be 10 $\mu$m or less, and may be 9 $\mu$m or less, or may be 8 $\mu$m.

For example, in a case in which an epoxy resin-based adhesive is used, by setting the thickness of the adhesive layer to about 10 $\mu$m, both adhesiveness and size stability against thermal behavior can be achieved at a high level.

<Magnetic Layer>

The magnetic layer in the magnetic shield sheet of the disclosure is a magnetic layer containing a magnetic material having a magnetostriction constant $\lambda$ of $30 \times 10^{-6}$ or less and having a thickness of from 8 $\mu$m to 24 $\mu$m.
In a case in which the magnetic material contained in the magnetic layer has a magnetostriction constant $\lambda$ of $30 \times 10^{-6}$ or less, either an amorphous material or a nanocrystalline material can be used as the magnetic material.
The thickness of the magnetic layer is in the range of from 8 $\mu$m to 25 $\mu$m, preferably in the range of from 10 $\mu$m to 20 $\mu$m, and more preferably in the range of from 12 $\mu$m to 18 $\mu$m, from the viewpoint of magnetic properties and strength.
The magnetostriction constant $\lambda$ of the magnetic material used for the magnetic layer may be a value adopted from a literature, or can be measured by the following method.

<Method of Measuring Magnetostriction Constant $\lambda$ of Magnetic Material>

The magnetostriction constant $\lambda$ can be measured using a strain sensor.
As the strain sensor, a strain sensor (model: SKF-40029) manufactured by Kyowa Electronic Instruments Co., Ltd. can be used.
The strain sensor is attached to the magnetic layer with an adhesive.
As the adhesive, a room-temperature curable instantaneous adhesive CC-33A manufactured by Kyowa Electronic Instruments Co., Ltd. is used. The adhesive is spread by dropping the adhesive in a roll rotation direction of the magnetic material (that is, the longitudinal direction) or a direction orthogonal thereto (that is, the width direction) and applying finger pressure, so that the strain sensor adheres to a free surface in a region where the adhesive is applied.
A measurement is performed on the obtained laminated body including the magnetic material, the adhesive, and the sensor, using a strain amplifier (model: PCD-300A) manufactured by Kyowa Electronic Instruments Co., Ltd. as a strain amplifier.
Assuming that a size of a magnetic material sample is 10 mm × 10 mm, the laminated body is fixed to the center of an electromagnet of a measurement device using a jig.
The measurement is performed by applying a magnetic field to the magnetic material at a magnetic field strength of about 5700 Oe.
The nanocrystalline material suitable for the magnetic layer can be obtained by quenching a molten metal having an alloy composition that can be adjusted to a nanocrystalline structure such as a Fe-Cu-Nb-(Si,B)-based nanocrystalline structure, molding the molten metal into an elongated body called an amorphous ribbon, and then adjusting the molded molten metal to a nanocrystalline structure by heat treatment. As an example, the nanocrystalline material may be a material in which at least 50% or more of the structure is composed of fine crystal grains having an average crystal grain size of 100 nm or less.
The nanocrystalline material can be obtained by producing an amorphous ribbon and then subjecting the amorphous ribbon to a heat treatment at a temperature equal to or higher than a crystallization temperature to be microcrystallized.
The obtained magnetic ribbon of amorphous alloy or nanocrystalline alloy can be used as the magnetic layer by arranging a plurality of magnetic ribbons in parallel to partially overlap the end portions of the magnetic materials so as to be magnetically and electrically coupled to each other, as illustrated in Fig. 3A described above.
The total thickness of the laminated body including the first resin layer, the first adhesive layer, the magnetic layer, the second adhesive layer, and the second resin layer in this order is preferably in the range of from 33 $\mu$m to 65 $\mu$m, more preferably in the range of from 35 $\mu$m to 62 $\mu$m, and still more preferably in the range of from 40 $\mu$m to 60 $\mu$m.
When the total thickness of the laminated body is within the above-described range, the magnetic shield sheet of the disclosure has superior flexibility and workability, and exhibits sufficient strength for practical use.

<Embodiment of Magnetic Shield Sheet>

Embodiments of the magnetic shield sheet of the disclosure are not particularly limited.
The magnetic shield sheet of the disclosure may be continuous in the longitudinal direction, may be a sheet having any given shape, such as one rectangular sheet independent of the other rectangular sheets, or may be a magnetic shield member obtained by punching a continuously formed sheet that is a rectangular sheet into any given shape.
The magnetic shield sheet of the disclosure may be a wound roll-shaped magnetic shield sheet.
By winding the laminated body to form a roll-shaped magnetic shield sheet, storage and conveyance are facilitated, and the magnetic shield sheet can be unwound for use as necessary.
The magnetic shield sheet stored in the rolled form and unwound as necessary can be cut into an appropriate size for use, or can be subjected to punching processing.

In addition, the magnetic shield sheet of the disclosure may be a magnetic shield member obtained by punching the laminated body into any given shape.

By punching the laminated body, it is possible to obtain a magnetic shield member of any given shape made of a magnetic shield sheet, and it is possible to easily incorporate the magnetic shield member into various devices.

Examples of the application of the magnetic shield member obtained by punching into any given shape include a countermeasure against noise for a camera, a medical device having an image processing function, or the like.

<Preferred Physical Properties of Magnetic Shield Sheet>

The first adhesive layer and the second adhesive layer contain a thermosetting adhesive. When an area change rate of the first resin layer between before and after heating at a temperature for curing the thermosetting adhesive is defined as A%, and a thickness of the first resin layer is B $\mu$m, a product of A and B is preferably 30%•$\mu$m or less.

The second resin layer preferably has physical properties that are similar to those of the first resin layer.

The area change rate between before and after heating to the temperature for curing the thermosetting adhesive is measured by the following method.

(Method of Measuring Area Change Rate)

According to JIS C 2151:2019, ASTM DD1204, a sample is prepared by cutting out a resin film constituting the first resin layer into a size of 100 mm $\times$ 100 mm, the obtained sample of the resin film is heated in a heat treatment furnace under the condition of 200°C $\times$ 10 min or 150°C $\times$ 30 min according to the temperature for curing the thermosetting adhesive, thermal shrinkage rates in the width direction and the length direction of the resin film before and after the heating are measured by the following method, an area is calculated from the product of the obtained width and length, and an area change rate is measured by the following Formula (a).

An area change rate for the second resin layer is also measured under conditions similar to those for the first resin layer.

area change rate (%) = [area of resin film before heating - area of resin film after heating]/area of resin film before heating.

- Method of Measuring Thermal Shrinkage Rate -

(1) A size in the width direction and a size in the length direction of a test piece before heating are measured.

(2) The test piece is placed in a hot air circulating thermostatic chamber, and suspended in a state with a load under time and temperature conditions corresponding to the material of the resin film.

Here, as described above, the load may be appropriately selected according to conditions under which the resin film is suspended in a state in which deformation of the resin film is suppressed.

(3) After heating, the test piece is cooled to room temperature, and then a size in the width direction and a size in the length direction of the test piece after the heat treatment are measured for the same portion as the test piece measured previously before heating.

(4) Using the obtained value, a thermal shrinkage rate is obtained according to the following Formula (b).

$$\text{Formula (b): thermal shrinkage rate (dimensional change rate) (\%)} = 100 \times (L_o\text{-}L)/L_o$$

In Formula (b), $L_o$ denotes a size of the test piece before the heating test, and L denotes a size of the test piece after the heating treatment.

Here, for example, in a case in which the thermosetting adhesive is aramid, heating may be performed under the condition of 200°C $\times$ 10 min, and in a case in which the thermosetting adhesive is another thermosetting adhesive, e.g., an epoxy resin, heating may be performed under the condition of 150°C $\times$ 30 min.

According to the study of the present inventors, it has been found that the heat resistance of the resin contained in the resin layer and the adhesive layer is important for the stability of the magnetic permeability of the magnetic shield sheet, and furthermore, the dimensional stability of each resin layer and each adhesive layer against thermal conditions such as heating and cooling is important, and in addition to the type of resin the thickness of each layer affects the heat resistance of the resin and the dimensional stability of each layer.

In a case in which the product of the area change rate of each of the first resin layer and the second resin layer between before and after heating and the thickness of each of the first resin layer and the second resin layer is calculated as 30%·µm or less according to the above-described measurement method, undesirable deformation or the like of the magnetic layer in the magnetic shield sheet between before and after heating is effectively suppressed.

The thickness of each of the first resin layer and the second resin layer refers to a thickness of a single layer for each of the first resin layer and the second resin layer.

<Method of Manufacturing Magnetic Shield Sheet>

As a method of manufacturing a magnetic shield sheet, a known method can be applied.

The magnetic shield sheet of the disclosure can be manufactured, for example, by a manufacturing method and a manufacturing apparatus described in JP-ANo. 2007-43077.

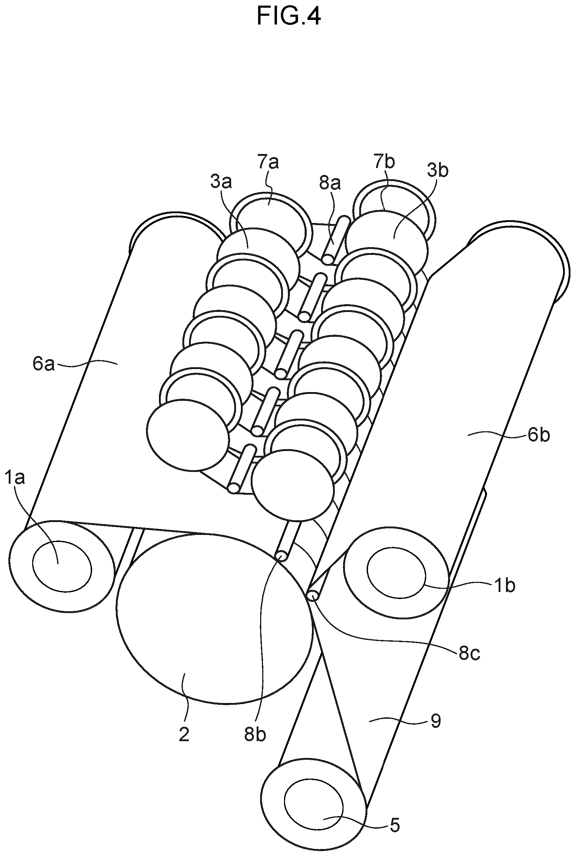

Fig. 4 is a perspective view illustrating an example of a main part of a manufacturing apparatus capable of manufacturing the magnetic shield sheet of the disclosure.

The manufacturing apparatus illustrated in Fig. 4 mainly includes a heat roll 2, resin rolls 1a and 1b disposed around the heat roll 2 for conveying a resin layer, ribbon coils 3a and 3b for conveying a magnetic layer, pressure-bonding rolls 8a, 8b, and 8c for pressure-bonding the magnetic layer and the resin layer, and a roll 5 for winding the stacked magnetic shield sheet.

In Fig. 4, all the rotation axes are arranged in parallel to each other.

In Fig. 4, a resin film 6a to be a first resin layer is unwound from the resin roll 1a toward the heat roll 2. An adhesive for forming an adhesive layer is applied onto one side of the resin film.

On the resin film 6a having an uncured adhesive layer on one surface thereof, amorphous alloy ribbons 7a and 7b that form a magnetic layer are unwound from the ribbon coils 3a and 3b at the same speed as the resin film while applying a tension of, for example, $3.0 \times 10^6$ to $1.2 \times 10^7$ (Pa) per unit cross-sectional area, and are arranged in parallel on the heat roll 2.

Note that amorphous alloy ribbons that form a magnetic layer may be drawn out from a plurality of unwinding rolls arranged in different stages so as to be magnetically and electrically coupled to one another, the amorphous alloy ribbons being drawn out such that all surfaces thereof contacting the heat roll for heating face one side, and being arranged in parallel such that end portions thereof overlap one another.

The amorphous alloy ribbons are drawn out from the respective rolls at the same speed and brought into contact with the circumference of the heat roll 2, and then immediately pressure-bonded to the resin film 6a having the adhesive layer thereon by the pressure-bonding rolls 8a and 8b.

More precisely, for example, the amorphous alloy ribbons 7a may be pressure-bonded onto the resin film at predetermined intervals and immediately pressure-bonded by the pressure-bonding roll 8a, and then portions not covered with the amorphous alloy ribbons 7a may be covered with the amorphous alloy ribbons 7b and the amorphous alloy ribbons 7b are immediately pressure-bonded by the pressure-bonding roll 8b.

The amorphous alloy ribbons are brought into contact with the resin film and pressure-bonded by the heat roll and the pressure-bonding roll.

Next, a resin film 6b is unwound from the resin roll 1b to form a second resin layer that is a layer higher than the surface covered with the amorphous alloy ribbons 7a and 7b. An adhesive constituting a second adhesive layer is applied onto the resin film 6b. The resin film 6b is pressure-bonded to the amorphous alloy ribbons 7a and 7b by the pressure-bonding roll 8c, thereby manufacturing a shielding material 9 as a magnetic shield sheet that is a laminated body including the resin film 6a forming the first resin layer and the first adhesive layer, the amorphous alloy ribbons 7a and 7b forming the magnetic layer, and the resin film 6b forming the second adhesive layer and the second resin layer.

The obtained magnetic shield sheet may be wound around a core material in the same direction as the direction in which the amorphous alloy ribbon of the first roll is bent to obtain a magnetic shield sheet roll.

The magnetic shield sheet may be conveyed after being wound by the roll 5, or may be cut into rectangular sheets, rather than being wound by the roll 5, and stored and conveyed in state where the rectangular sheets are stacked.

In a case in which the adhesive layer contains a thermosetting adhesive, after the laminated body is formed and before the laminated body is wound or cut, a step of curing the adhesive layer by heat treatment may be carried out.

Since the magnetic shield sheet of the disclosure has the above-described configuration, the magnetic layer is effectively protected, and undesired deterioration of the magnetic layer caused by heat treatment is suppressed. In addition, the magnetic shield sheet of the disclosure has an AC relative magnetic permeability µ' that is sufficient for practical use, and has an advantage that a change with time is suppressed.

Examples

Hereinafter, the disclosure will be described in detail by way of examples. However, the disclosure is not limited to the following examples.

<Example 1>

First, a ribbon having a width of 50 mm that was an alloy ribbon FT-3 (manufactured by Proterial, Ltd., magnetostriction constant: $\lambda < 1 \times 10^{-6}$) cast by a single roll method before heat treatment processing was prepared as an alloy ribbon for a magnetic layer.

An aramid film (melting point: 278°C, manufactured by Toray Industries, Inc.) having a thickness of 4.4 $\mu$m that was a resin layer to which an epoxy resin (heat-resistant temperature: 200°C, manufactured by Toray Industries, Inc.) was bonded was prepared as an adhesive layer. The adhesive was applied in such an amount that the thickness of the adhesive after being cured was 10 $\mu$m.

A core having a length of 250 m was created to allow the FT-3 ribbon to be attached to a magnetic shield laminate apparatus. At the time of producing the core, a nanocrystalline material was wound around a winding core in a direction in which a roll surface of the nanocrystalline material faced the inner circumference.

Here, the roll surface of the nanocrystalline material refers to a surface of the ribbon of nanocrystalline material cast by the single roll method in contact with a casting roll for manufacturing the ribbon.

After producing the core, the core was removed from the winding core, and this core was heat-treated at 590°C for 1 hour to be used as an FT-3 nanocrystalline material core for a magnetic layer.

Next, in order to form a magnetic shield sheet by thermally pressure-bonding the magnetic layer, the FT-3 nanocrystalline material core and the prepared adhesive-attached aramid film were attached to the laminate apparatus.

As the laminate apparatus, a manufacturing apparatus having the partial structure illustrated in Fig. 4 as described in JP-ANo. 2007-43077 was used.

Using this manufacturing apparatus, a nanocrystalline material FT-3M, which was a magnetic layer, an aramid film to be a first resin layer formed as a protective resin film with a sheet-like epoxy resin that was a first adhesive layer, and an aramid film to be a second resin layer formed as a protective resin film with a sheet-like epoxy resin that was a second adhesive layer were heated and temporarily pressure-bonded with a pressure-bonding roll under manufacturing conditions including a heating heat roll temperature of 60°C and a line speed of 1 m/min.

At this stage, the adhesive was not crosslinked and cured. In order to wind the heated and temporarily pressure-bonded laminated body as a long roll, the laminated body was continuously wound around a winding core. As the winding core, a paper tube was used in consideration of heat resistance.

Next, in order to form an adhesive layer by crosslinking and curing the uncured epoxy adhesive, a thermal curing treatment was performed in a heat treatment furnace. The heat treatment was performed under conditions including a temperature of 170°C and a treatment time of 2 hours.

A magnetic shield sheet of Example 1 has a layer configuration as illustrated in Fig. 1.

After the inside of the heat treatment furnace was cooled to normal temperature (25°C), the magnetic shield sheet of Example 1 having a cross section as illustrated in Fig. 1, including a first resin layer 12, a cured first adhesive layer 14, a magnetic layer 16, a cured second adhesive layer 18, and a second resin layer 20, was obtained.

<Comparative Example 1>

A polyethylene terephthalate film (PET, melting point: not disclosed, manufactured by Kurabo Industries Ltd.) having a thickness of 25 $\mu$m was used for forming a resin layer, and a polyolefin-based adhesive (melting point: 90°C, manufactured by Kurabo Industries Ltd.) was used to form an adhesive layer having a thickness of 25 $\mu$m in the formation of the resin layer. Although the catalog value is not disclosed, a general PET film has a heat-resistant temperature of lower than 200°C.

Under the manufacturing conditions of the laminate apparatus including a heating heat roll temperature of 110°C and a line speed of 2.5 m/min, the laminated body was heated and pressure-bonded by a pressure-bonding roll.

A magnetic shield sheet of Comparative Example 1 was obtained in a similar manner as that of Example 1, except that the thermal curing treatment performed in Example 1 was not carried out.

Table 1 shows a magnetic shield material composition and a thickness of each layer in each of Example 1 and Comparative Example 1.

[Table 1]

| | Example 1 | | Comparative Example 1 | |
|---|---|---|---|---|
| | Material | Thickness (μm) | Material | Thickness (μm) |
| Magnetic layer | FT-3M (Nanocrystalline material) | 18 | FT-3M (Nanocrystalline material) | 18 |
| First resin layer Second resin layer | Aramid (mp: 278°C) | 4.4 | Polyethylene terephthalate (mp: >200°C) | 25 |
| First adhesive layer Second adhesive layer | Epoxy resin (Heat-resistant temperature: 200°C) | 10 | Polyolefin resin (mp: 90°C) | 25 |
| Total thickness of laminated body | | 46.8 | | 118 |

As is clear from Table 1, the magnetic shield sheet of Example 1 has a thickness smaller than or equal to half of the thickness of the magnetic shield sheet of Comparative Example 1, from which it can be seen that the size can be reduced.

<Evaluation>

<1. Evaluation of Appearance Related to Heat Resistance>

The magnetic shield sheets of Example 1 and Comparative Example 1 were evaluated for heat resistance, mainly for appearance before and after heat resistance tests.

This evaluation was performed by a high storage reliability test at 130°C for 1000 hours. That is, each of the magnetic shield sheets of Example 1 and Comparative Example 1 was placed in a thermostatic chamber and heated at 130°C for 1000 hours, and a change in entire appearance of the magnetic shield sheet between before and after the heating and an appearance of each layer were observed in detail for evaluation.

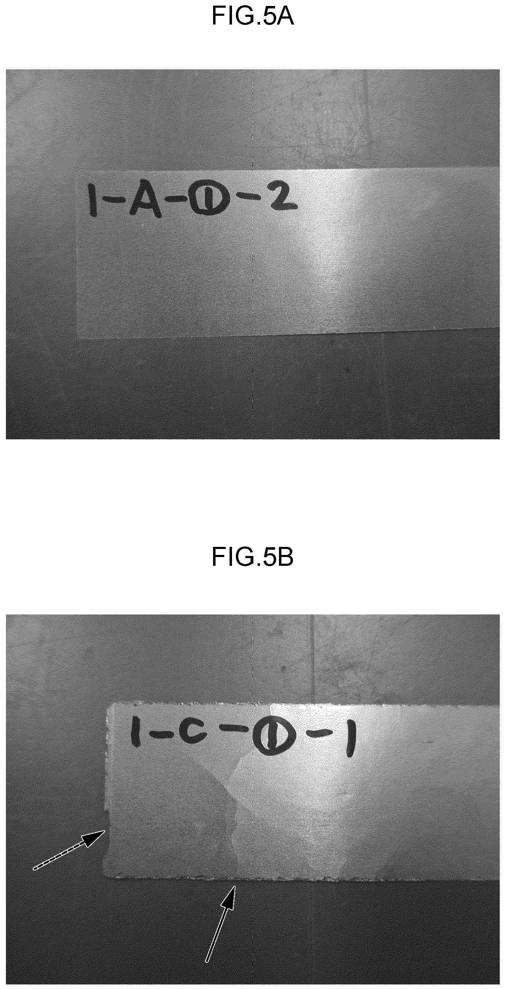

Fig. 5A is a partially enlarged view of a photograph of the magnetic shield sheet of Example 1 in which the appearance has changed after the high storage reliability test, and Fig. 5B is a partially enlarged view of a photograph of the magnetic shield sheet of Comparative Example 1 in which the appearance has changed after the high storage reliability test.

As shown in Fig. 5A, in the magnetic shield sheet of Example 1, discoloration of the adhesive caused by the high temperature was observed in the appearance after the test, but the uniformity of the laminated body was maintained overall, and no damage was observed to the nanocrystalline material, which was a magnetic layer.

On the other hand, as shown in Fig. 5B, in the magnetic shield sheet of Comparative Example 1, it was observed that the appearance was not uniform overall, and the nanocrystalline material, which was a magnetic layer, was exposed at an end thereof due to cracks in the magnetic layer and deformation caused by shrinkage of the PET film, which was a resin layer, as a result of which the nanocrystalline material fell off. In Fig. 5B, a solid-line arrow indicates a crack in the magnetic layer, and a broken-line arrow indicates a falling-off portion of the magnetic layer at the end.

<2. Evaluation of Magnetic Permeability>

A change in maximum magnetic permeability (μm) of each of the magnetic shield sheets of Example 1 and Comparative Example 1 during the high storage reliability test was measured.

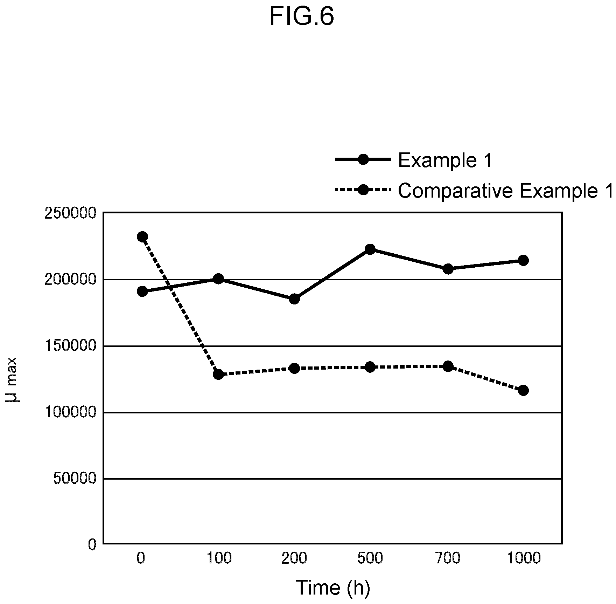

Fig. 6 shows a graph for a change in maximum magnetic permeability with the passage of heating time. In Fig. 6, the horizontal axis indicates a time elapsed from the start of heating at 130°C, and the vertical axis indicates a maximum magnetic permeability.

A method of evaluating a maximum magnetic permeability is as follows.

(Method of Evaluating Maximum Magnetic Permeability)

A maximum magnetic permeability (μm) was measured, using a single-plate magnetic measuring frame, on a sample cut out into a size of 15 mm × 200 mm using a direct current magnetic property measuring apparatus manufactured by Metron Technology Research Co., Ltd.

As shown in the graph of Fig. 6, in the magnetic shield sheet of Example 1, the maximum magnetic permeability

$\mu$m even after 1000 hours had passed was equivalent to that before the start of the test, and no significant change in maximum magnetic permeability was observed even during the test under the heating conditions.

On the other hand, in the magnetic shield sheet of Comparative Example 1, it can be seen that the maximum magnetic permeability $\mu$m significantly decreased within 100 hours after the start of the heating test. It is considered that the decrease in maximum magnetic permeability is affected by the deterioration in appearance of the nanocrystalline material as the magnetic layer shown in Fig. 5B.

From the above test results, it can be seen that the magnetic shield sheet of Example 1 has excellent heat resistance in both appearance and performance as compared with the magnetic shield sheet of Comparative Example 1.

<Measurement of Magnetic Permeability by Frequency>

A magnetic permeability ($\mu$') of each of the magnetic shield sheet of Example 1 and the magnetic shield sheet of Comparative Example 1 was measured at a frequency of 1 kHz and at a frequency of 10 kHz for comparison.

The magnetic permeability $\mu$' was measured, using an impedance analyzer, Model 4194A, manufactured by Hewlett Packard Enterprise, with an inductance L measured under the conditions including one sample layer, 10 turns of winding, and an OSC level of 0.5 V, according to the following calculation formula.

$$\mu' = (L \times \text{average magnetic path length})/(\mu_0 \times \text{effective cross-sectional area})$$

A measurement sample was prepared by punching the magnetic shield sheet into a ring shape having an outer diameter of 43 mm and an inner diameter of 25 mm with a hand press machine.

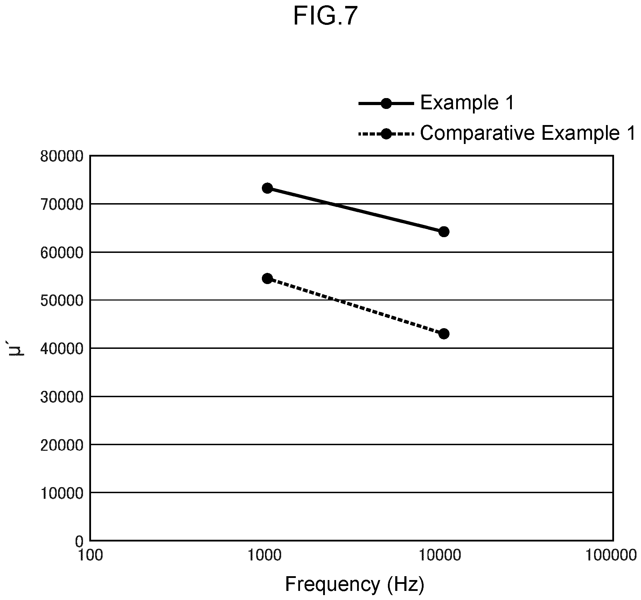

Fig. 7 shows measurement results.

It has been seen that the magnetic shield sheet of Example 1 can obtain a higher magnetic permeability $\mu$' than that of Comparative Example 1 at the frequencies of 1 kHz and 10 kHz that are practically used for general purposes.

<Example 2>

A magnetic shield sheet of Example 2 was obtained in the same manner as in Example 1, except that the thickness of each of the first resin layer and the second resin layer in Example 1 was changed to 12 $\mu$m.

<Comparative Example 2>

A magnetic shield sheet of Comparative Example 2 was obtained in the same manner as in Example 1, except that a polyphenylene sulfide (PPS) resin (melting point: from 260°C to 270°C, manufactured by Toray Industries, Inc.) was used for each of the first resin layer and the second resin layer and the thickness was changed to 25 $\mu$m.

Table 2 shows a magnetic shield material composition and a thickness of each layer in each of Example 2 and Comparative Example 2.

Table 2]

| | Example 2 | | Comparative Example 2 | |
|---|---|---|---|---|
| | Material | Thickness ($\mu$m) | Material | Thickness ($\mu$m) |
| Magnetic layer | FT-3M (Nanocrystalline material) | 18 | FT-3M (Nanocrystalline material) | 18 |
| First resin layer Second resin layer | Aramid (mp: 278°C) | 12 | PPS (mp: 260°C to 270°C) | 25 |
| First adhesive layer Second adhesive layer | Epoxy resin (Heat-resistant temperature: 200°C) | 10 | Epoxy resin (Heat-resistant temperature: 200°C) | 10 |
| Total thickness of laminated body | | 62 | | 88 |

<Measurement of Magnetic Permeability by Frequency>

A magnetic permeability ($\mu$') of each of the magnetic shield sheets of Example 2 and Comparative Example 2 was measured at a frequency of 1 kHz and at a frequency of 10 kHz for comparison, in the same manner as that of each of the magnetic shield sheets of Example 1 and Comparative Example 1.

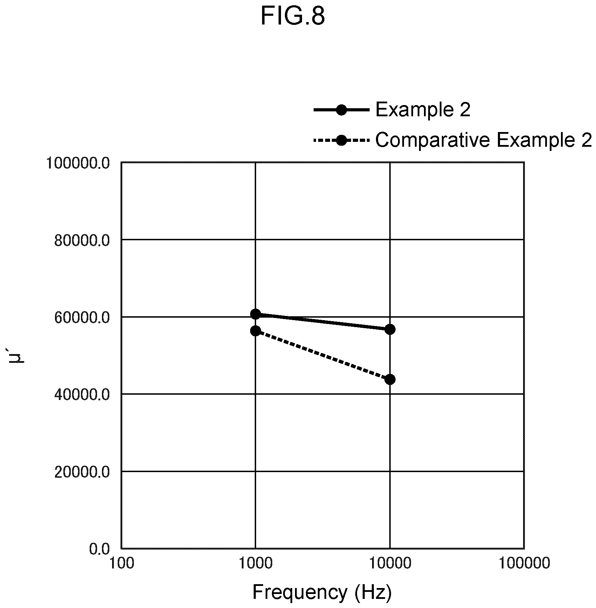

The results are shown in Fig. 8.

From Figs. 7 and 8, the frequencies of 1 kHz and 10 kHz in Examples 1 and 2 and Comparative Examples 1 and 2 are as shown below, and it can be seen that the magnetic shield sheets of the examples have higher magnetic permeabilities and exhibit excellent performances as compared with the magnetic shield sheets of the comparative examples.

Magnetic permeability in Example 1 (1 KHz: 73221.6 μ'), (10 KHz: 64423.7 μ')

Magnetic permeability in Comparative Example 1 (1 KHz: 54482.7 μ'), (10 KHz: 42962.9 μ')

Magnetic permeability in Example 2 (1 KHz: 60866.1 μ'), (10 KHz: 56930.9 μ')

Magnetic permeability in Comparative Example 2 (1 KHz: 56605.7 μ'), (10 KHz: 43734.6 μ')

From the above evaluation results, it can be seen that the performance of the magnetic shield sheet is affected by the heat resistance, particularly the heat resistance and thickness of the resin layer, which functions as a layer that protects the magnetic layer. In other words, it was found that the dimensional stability of each resin layer between before and after heating affected the magnetic layer protecting performance.

The resin film constituting the resin layer has a thermal expansion or a thermal shrinkage at the time of heating that varies depending on the material and thickness of the resin, which affects the protection of the magnetic layer.

By suppressing the product of the area change rate of each resin film after the heat treatment with respect to that before the heat treatment and the thickness of the resin layer to a predetermined range, the magnetic permeability of the magnetic shield sheet can be maintained at a high level.

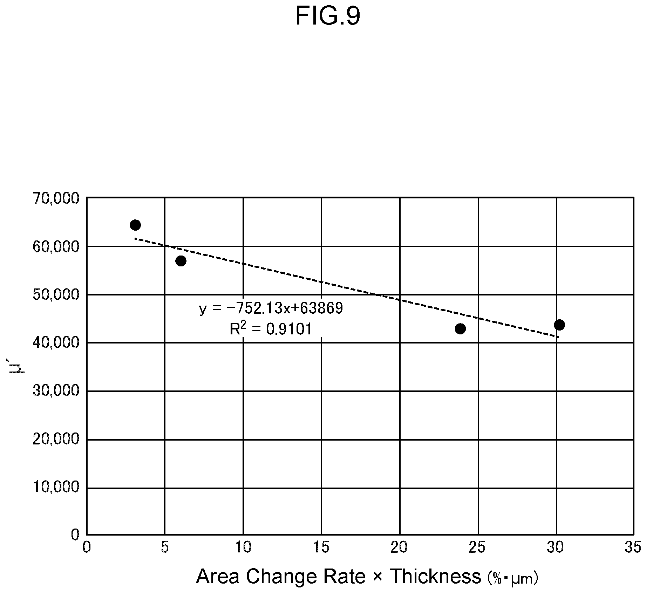

For the purpose of verification, a relationship between the product of the area change rate of each resin film after the heat treatment with respect to that before the heat treatment and the thickness of the resin layer and the magnetic permeability μ' of the obtained magnetic shield sheet was measured, and the results are shown in Fig. 9.

The marks • illustrated in Fig. 9 indicate the results of Example 1, Example 2, Comparative Example 1, and Comparative Example 2 from the left.

For example, in the aramid resin (thickness: 4.4 μm) used in Example 1, the area change rate measured under the following conditions was 0.997%, or 0.997×4.4=4.39 (%•μm), which achieved 30%•μm or less, and also obtained favorable results in the evaluation of heat resistance.

<Product of Area Change Rate of Magnetic Shield Sheet and Thickness of Resin Sheet, and Maximum Magnetic Permeability at Frequency of 10 kHz>

In the magnetic shield sheet, when the area change rate of each of the first resin layer and the second resin layer measured under the following conditions was A%, and the thickness of each of the first resin layer and the second resin layer was B μm, the product (%•μm) of A and B and the maximum magnetic permeability were measured. The results are shown in Fig. 6.

(Method of Measuring Area Change Rate)

A sample was prepared by cutting out a resin film, which constituted the first resin layer and the second resin layer, into a size of 100 mm × 100 mm, and the obtained sample of the resin film was heated in a heat treatment furnace at 200°C for 10 minutes for an aramid resin and at 150°C for 30 minutes for another adhesive to correspond to a temperature for curing a thermosetting adhesive, areas of the resin film before and after heating were measured, and an area change rate was calculated by the following Formula (a).

area change rate (%) = [area of resin film before heating - area of resin film after heating]/area of resin film before heating.

- Method of Measuring Thermal Shrinkage Rate -

(1) A size in the width direction and a size in the length direction of a test piece before heating were measured.

(2) The test piece was placed in a hot air circulating thermostatic chamber, and suspended in a state with a load under time and temperature conditions corresponding to the material of the resin film.

(3) After heating, the test piece was cooled to room temperature, and then a length of the test piece after the heat treatment was measured for the same portion as the test piece measured previously before heating.

(4) Using the obtained value, a thermal shrinkage rate was obtained according to the following Formula (b).

$$\text{Formula (b): thermal shrinkage rate (dimensional change rate) (\%)} = 100 \times (Lo\text{-}L)/Lo$$

In Formula (b), Lo denotes a size of the test piece before the heating test, and L denotes a size of the test piece after the heating treatment.

As described above, the load at the time of suspension was adjusted to such a load that the resin film was suspended without being deformed.

As shown in Fig. 9, it can be seen that when the product (%•$\mu$m) of A and B is 30%•$\mu$m or less, the maximum magnetic permeability that poses no practical problem is exhibited at the frequency of 10 kHz.

That is, it was confirmed that a magnetic shield sheet having a high magnetic permeability can be obtained by further reducing the area change rate of the resin layer itself or the laminated body and the thickness of the resin layer.

Description of Reference Numerals

1    Resin film roll
2    Heat roll
3    Alloy ribbon roll
4    Magnetic layer (amorphous alloy ribbon)
5    Winding machine
6    Resin layer (resin film)
7    Alloy ribbon coil
8    Pressure-bonding roll
9    Magnetic shield sheet material
10   Magnetic shield sheet
12   First resin layer
14   First adhesive layer
16   Magnetic layer
18   Second adhesive layer
20   Second resin layer
22   Magnetic shield sheet
24   First resin layer
26   First adhesive layer
28   Magnetic layer
30   Second adhesive layer
32   Second resin layer

**Claims**

1.  A magnetic shield sheet comprising a laminated body having a first resin layer, a first adhesive layer, a magnetic layer, a second adhesive layer, and a second resin layer in this order, wherein:

    the magnetic layer contains a magnetic material having a magnetostriction constant $\lambda$ of $30 \times 10^{-6}$ or less, the magnetic layer having a thickness of from 8 $\mu$m to 25 $\mu$m,
    each of the first resin layer and the second resin layer contains a resin having a melting point or a sublimation point of 250°C or higher, and has a thickness of from 1 $\mu$m to 24 $\mu$m, and
    each of the first adhesive layer and the second adhesive layer contains an adhesive having a melting point of 150°C or higher, and has a thickness of from 1 $\mu$m to 10 $\mu$m.

2.  The magnetic shield sheet according to claim 1, wherein:

the magnetic layer is an elongated body having a width of from 30 mm to 500 mm,

each of the first resin layer, the first adhesive layer, the second adhesive layer, and the second resin layer has a width of 300 mm or more, and

a plurality of the magnetic layers are arranged in parallel in a longitudinal direction of the elongated body on a surface of the first adhesive layer at an opposite side from a side having the first resin layer.

3. The magnetic shield sheet according to claim 1 or 2, wherein a total thickness of the laminated body is from 33 $\mu$m to 65 $\mu$m.

4. The magnetic shield sheet according to claim 1 or 2, configured in a wound roll shape.

5. The magnetic shield sheet according to claim 1, wherein the magnetic shield sheet is a magnetic shield member obtained by punching the laminated body into any given shape.

6. The magnetic shield sheet according to claim 1 or 2, wherein:

the first adhesive layer and the second adhesive layer contain a thermosetting adhesive,when an area change rate of at least one of the first resin layer or the second resin layer between before

and after heating at a temperature for curing the thermosetting adhesive is A%, and a thickness of each of the first resin layer and the second resin layer is B $\mu$m, a product of A and B is 30%•$\mu$m or less,

a method of measuring the area change rate is such that, in accordance with JIS C 2151:2019, ASTM DD1204, a sample is prepared by cutting out a resin film configuring the first resin layer and the second resin layer to a size of 100 mm × 100 mm, the obtained sample of the resin film is heated in a heat treatment furnace under a condition of 200°C × 10 min or 150°C × 30 min according to the temperature for curing the thermosetting adhesive, thermal shrinkage rates in a width direction and a length direction of the resin film before and after the heating are measured by the following method, an area is calculated from the product of the obtained width and length, and an area change rate is measured by the following Formula (a):

area change rate (%) = absolute value of [area of resin film before heating - area of resin film after heating]/ area of resin film before heating, and and

a method of measuring thermal shrinkage rate is such that:

(1) a size in the width direction and a size in the length direction of a test piece before heating are measured;

(2) the test piece is placed in a hot air circulating thermostatic chamber, and suspended in a state with a load under time and temperature conditions corresponding to the material of the resin film;

(3) after heating, the test piece is cooled to room temperature, and then a length of the test piece after the heat treatment is measured for the same portion as the test piece measured previously before heating; and

(4) using the obtained value, a thermal shrinkage rate is obtained according to the following Formula (b):

Formula (b): thermal shrinkage rate (dimensional change rate) (%) = $100 \times (Lo\text{-}L)/Lo$

wherein, in Formula (b), Lo denotes a size of the test piece before the heating test, and L denotes a size of the test piece after the heating treatment.

FIG.1

# FIG.2

# FIG.3A

EP 4 535 378 A1

# FIG.3B

20
18
16
16
14
12

# FIG.3C

20
18
16
16
14
12

# FIG.4

# FIG.5A

# FIG.5B

# FIG.6

# FIG.7

## FIG.8

# FIG.9

$$y = -752.13x + 63869$$
$$R^2 = 0.9101$$

μ´ (vertical axis)

Area Change Rate × Thickness (%·μm)

Europäisches
Patentamt

European
Patent Office

Office européen
des brevets

**EUROPEAN SEARCH REPORT**

Application Number

EP 24 20 3505

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 9 832 917 B2 (AMOSENSE) 28 November 2017 (2017-11-28) | 1-5 | INV. H01F1/153 |
| A | * column 8, line 4 - column 9, line 31 * * figures 1, 3 * | 6 | H05K9/00 |
| A | JP 2000 004094 A (HITACHI) 7 January 2000 (2000-01-07) * paragraphs [0004], [0011] * * figure 2 * * example 2 * | 1-6 | |
| A | WO 2014/054499 A1 (TOSHIBA) 10 April 2014 (2014-04-10) * paragraphs [0012], [0023] * | 1-6 | |

TECHNICAL FIELDS
SEARCHED        (IPC)

H05K
H01F

The present search report has been drawn up for all claims

| Place of search | Date of completion of the search | Examiner |
|---|---|---|
| Munich | 12 February 2025 | Subke, Kai-Olaf |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

                                                                            
& : member of the same patent family, corresponding
     document

EPO FORM 1503 03.82 (P04C01)

## ANNEX TO THE EUROPEAN SEARCH REPORT
## ON EUROPEAN PATENT APPLICATION NO.

EP 24 20 3505

This annex lists the patent family members relating to the patent documents cited in the above-mentioned European search report.
The members are as contained in the European Patent Office EDP file on
The European Patent Office is in no way liable for these particulars which are merely given for the purpose of information.

12-02-2025

| Patent document cited in search report | | Publication date | Patent family member(s) | | Publication date |
|---|---|---|---|---|---|
| US 9832917 | B2 | 28-11-2017 | CN | 104885587 A | 02-09-2015 |
| | | | KR | 101399022 B1 | 27-05-2014 |
| | | | US | 2015342099 A1 | 26-11-2015 |
| | | | WO | 2014104816 A1 | 03-07-2014 |
| JP 2000004094 | A | 07-01-2000 | NONE | | |
| WO 2014054499 | A1 | 10-04-2014 | CN | 104704937 A | 10-06-2015 |
| | | | CN | 109494042 A | 19-03-2019 |
| | | | JP | 6556452 B2 | 07-08-2019 |
| | | | JP | 6612923 B2 | 27-11-2019 |
| | | | JP | 2018157215 A | 04-10-2018 |
| | | | JP | WO2014054499 A1 | 25-08-2016 |
| | | | WO | 2014054499 A1 | 10-04-2014 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007317769 A

- JP 2007043077 A